# EUROPEAN PATENT APPLICATION

(11) **EP 4 746 648 A1**
(43) Date of publication of application: **20.05.2026**
(21) Application number: 25209762.1
(22) Date of filing: 20.10.2025
(51) Int. Cl.: H10H 29/37, H10H 29/856, H10H 29/80, H10H 29/85, H10H 29/852, H10H 29/855

(54) **ELECTRONIC DEVICE**

(30) Priority: 13.11.2024 CN 202411616852; 16.01.2025 CN 202510069773
(71) Applicant: InnoLux Corporation, Chu-Nan, Miao-Li 350 (TW)
(72) Inventor: PING-HSUN , TSAI, Jhu-Nan 350 Miao-Li County (TW); I-AN, YAO, Jhu-Nan 350 Miao-Li County (TW)
(74) Representative: dompatent

(57) **Abstract**

An electronic device includes a first substrate, a circuit layer, at least one electronic unit, a second substrate, a reflective layer and an optical layer. The circuit layer is disposed on the first substrate. The electronic unit is disposed above the first substrate and electrically connected to the circuit layer. The second substrate is disposed opposite to the first substrate and includes at least one light transmission area and at least one light reflection area. The light transmission area is located next to the light reflection area, and the light transmission area is arranged corresponding to the electronic unit. The reflective layer is disposed at one side of the second substrate close to the first substrate, and is located corresponding to the light reflection area. The optical layer is disposed between the second substrate and the electronic unit, and is located at least corresponding to the light transmission area.

## Description

### BACKGROUND

### Technology Field

The present invention relates to an electronic device and, in particular, to a micro LED mirror display device.

### Description of Related Art

With the development of technology, the display devices have been widely used in all aspects of daily life, such as TVs, computers, mobile phones and other modern information products. Among the common display devices, micro LED (light-emitting diode) display devices are one of the current mainstream products. In addition, the display devices with mirror functions (e.g. micro LED mirror display devices) have been introduced recently and gradually popularized. However, the mirror images of the micro LED mirror display devices may form granular color casts.

### SUMMARY

This invention provides an electronic device that can effectively reduce the intensity of reflected light with color cast at the positions corresponding to the LEDs and traces, thereby improving the granular color casts of the mirror image.

An electronic device of this invention includes a first substrate, a circuit layer, at least one electronic unit, a second substrate, a reflective layer and an optical layer. The circuit layer is disposed on the first substrate. The electronic unit is disposed above the first substrate and electrically connected to the circuit layer. The second substrate is disposed opposite to the first substrate and includes at least one light transmission area and at least one light reflection area. The light transmission area is located next to the light reflection area, and the light transmission area is arranged corresponding to the electronic unit. The reflective layer is disposed at one side of the second substrate close to the first substrate, and located corresponding to the light reflection area. The optical layer is disposed between the second substrate and the electronic unit, and located at least corresponding to the light transmission area.

An electronic device of this invention includes a first substrate, a circuit layer, at least one electronic unit, a second substrate, a reflective layer, and a reflection enhancement layer. The circuit layer is disposed on the first substrate. The electronic unit is disposed above the first substrate and electrically connected to the circuit layer. The second substrate is disposed opposite to the first substrate and includes at least one light transmission area and at least one light reflection area. The light transmission area is located next to the light reflection area, and the light transmission area is arranged corresponding to the electronic unit. The reflective layer is disposed at one side of the second substrate close to the first substrate, and located corresponding to the light reflection area. The reflection enhancement layer is disposed at one side of the second substrate away from the first substrate to reflect at least part of an ambient light.

### BRIEF DESCRIPTION OF THE DRAWINGS

The invention will become more fully understood from the detailed description and accompanying drawings, which are given for illustration only, and thus are not limitative of the present invention, and wherein:
FIG. 1 is a schematic sectional view of an electronic device according to a first embodiment of this invention;
FIGS. 2A to 2E and FIGS. 3A to 3D are schematic sectional views of different aspects of the electronic device according to the first embodiment of this invention;
FIG. 4 is a schematic sectional view of an electronic device according to a second embodiment of this invention;
FIGS. 5A to 5D are schematic sectional views of different aspects of the electronic device according to the second embodiment of this invention;
FIGS. 6A to 6D are schematic sectional views of different aspects of the electronic device according to a third embodiment of this invention;
FIG. 7 is a schematic sectional view of an electronic device according to a fourth embodiment of this invention;
FIG. 8 is a schematic sectional view of an electronic device according to a fifth embodiment of this invention;
FIGS. 9A and 9B are schematic sectional views of different aspects of the electronic device according to a sixth embodiment of this invention; and
FIG. 10 is a schematic sectional view of an electronic device according to a seventh embodiment of this invention.

### DETAILED DESCRIPTION OF THE INVENTION

The present invention will be apparent from the following detailed description, which proceeds with reference to the accompanying drawings, wherein the same references relate to the same elements.

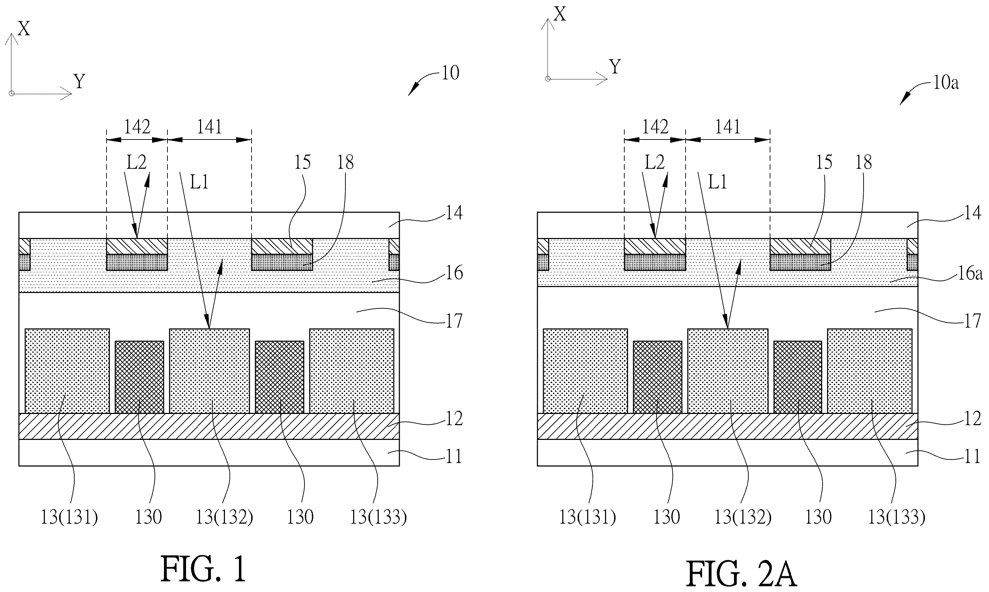

FIG. 1 is a schematic sectional view of an electronic device 10 according to a first embodiment of this invention.

As shown in FIG. 1, the electronic device 10 of this embodiment can be, for example, a mirror display device, especially a micro LED mirror display device. For example, FIG. 1 shows a sectional view of a pixel region of the electronic device 10, which is defined in a plane formed by a first direction X and a second direction Y.

In this embodiment of FIG. 1, the electronic device 10 includes a first substrate 11, a circuit layer 12, at least one electronic unit 13, a second substrate 14, a reflective layer 15, an optical layer 16, and an intermediate layer 17.

The first substrate 11 may include, for example but not limited to, transparent or non-transparent organic and/or inorganic materials, and the material thereof may include rigid material or flexible soft material. The organic material may include, for example but not limited to, polyimide (PI), polycarbonate (PC), polyethylene terephthalate (PET), or any of other known suitable materials, or a combination thereof. The inorganic material may include, for example but not limited to, glass, quartz, sapphire, or ceramic. In this embodiment, the material of the substrate 11 is glass as an example, so that the first substrate 11 is a glass substrate.

The circuit layer 12 is disposed on the first substrate 11 in the first direction X. The circuit layer 12 may include, for example, different passive components and/or active components, such as resistors, capacitors, inductors, diodes, MOSFETs, CMOS transistors, BJTs, LDMOS transistors, PMOS transistors, TFTs, or other types of transistors. In addition, the first substrate 11 and the circuit layer 12 can together constitute a driving substrate for driving the electronic unit 13, which can be, for example but not limited to, a CMOS substrate, a LCOS substrate, a TFT substrate, or other circuit substrates with operating circuits. In this embodiment, the first substrate 11 and the circuit layer 12 can together constitute, for example, a TFT substrate.

The electronic unit 13 is disposed over the first substrate 11 and electrically connected to the circuit layer 12. In this embodiment, the electronic unit 13 may be, for example, directly disposed on the circuit layer 12 and electrically connected to the circuit layer 12. In one embodiment, the electronic unit 13 may be, for example but not limited to, a light-emitting unit. In this case, a unit definition layer 130 (or pixel definition layer) may be formed on the circuit layer 12, and it may be made of, for example, a negative photoresist and have a plurality of accommodating spaces arranged along the second direction Y. Each electronic unit 13 (light-emitting unit) may, for example, include three light-emitting elements 131, 132 and 133, which are respectively arranged in the accommodating spaces of the unit definition layer 130. In other embodiments, each electronic unit 13 may include any suitable active or passive components. For example, each light-emitting element 131, 132 or 133 may include an organic LED (OLED), an inorganic LED (e.g. mini LED or micro LED), or a quantum-dot LED (QLED), but the present invention is not limited thereto. In this embodiment, the three light-emitting elements 131, 132 and 133 may be, for example, a red micro LED, a green micro LED, and a blue micro LED, respectively.

The second substrate 14 is disposed opposite to the first substrate 11 and includes at least one light transmission area 141 and at least one light reflection area 142. The light transmission area 141 is disposed next to the light reflection area 142. In this embodiment, the second substrate 14 includes a plurality of light transmission areas 141 and a plurality of light reflection areas 142, which are disposed adjacent to each other and are alternately arranged. The plurality of light transmission areas 141 are arranged corresponding to the plurality of light-emitting elements 131, 132 and 133 of the electronic unit 13, respectively. The second substrate 14 may be, for example but not limited to, a transparent substrate, such as a glass substrate. In addition, the width of the light transmission area 141 may be equal to, slightly larger than, or slightly smaller than the width of the corresponding electronic unit 13.

The reflective layer 15 is disposed at one side of the second substrate 14 close to the first substrate 11 and corresponding to the light reflection area 142. In this embodiment, a reflective material layer may be formed on one side of the second substrate 14, and then the portions of the reflective material layer corresponding to the plurality of light transmission areas 141 are removed. Accordingly, the residual portions of the reflective material layer corresponding to the plurality of light reflection areas 142 can form the reflective layer 15. The material of the reflective layer 15 can be, for example, a single metal layer, a composite metal layer, a multilayer film material, or a layer of any of other suitable materials. The single metal layer may include, for example, silver, aluminum, or the likes. The composite metal layer may include, for example, a composite structure of metals and metal oxides, such as, for example but not limited to, ITO/Ag/ITO, Ag/ITO, Al/Ag/Al, Ag/Al, or the likes. The multilayer film material may include, for example, a multilayer film with at least three layers of different refractive indices, wherein the high refractive layers and the low refractive layers are interposed with each other. The low refractive material can be, for example but not limited to, SiOx, and the high refractive material can be, for example but not limited to, SiNx, niobium oxide (Nb₂O₅), or the likes.

The optical layer 16 is disposed between the second substrate 14 and the electronic unit 13, and at least corresponding to the light transmission area 141. The intermediate layer 17 is disposed between the first substrate 11 and the second substrate 14. In this embodiment, as shown in FIG. 1, the optical layer 16 is disposed on the intermediate layer 17 in the first direction X. In other words, the optical layer 16 is located relatively close to the second substrate 14, and the intermediate layer 17 is located relatively close to the first substrate 11.

The optical layer 16 can be used to scatter, polarize or refract the incident ambient light, thereby effectively reducing the intensity of the reflected light with color casts at the positions corresponding to the electronic unit 13 and the circuit layer 12, thereby improving the granular color cast phenomenon of the mirror image. For example, the optical layer 16 may include scattering particles, a circular polarizer, a low-refractive material containing scattering microstructures, a micro-lens structure with a high refractive index, or the likes.

The intermediate layer 17 can be, for example but not limited to, an air medium, an optical clear adhesive (OCA), or an optical clear resin (OCR), which is not limited in the present invention. In one embodiment, when manufacturing the electronic device 10, the circuit layer 12 and the electronic unit 13 can be disposed on the first substrate 11, and the reflective layer 15 and the optical layer 16 can be disposed on the second substrate 14. Then, a sealant can be provided to bond the structures on the first substrate 11 and the structures on the second substrate 14. In this case, the intermediate layer 17 can be, for example, an air medium. In another embodiment, an adhesive material layer can be used to bond the structures on the first substrate 11 and the structures on the second substrate 14. The adhesive material layer can be, for example, an optical clear adhesive or an optical clear resin. In this case, the intermediate layer 17 can be, for example, a layer including the optical clear adhesive or the optical clear resin.

In addition, the electronic device 10 may further include a light absorbing layer 18 disposed between the reflective layer 15 and the intermediate layer 17. As shown in FIG. 1, the light absorbing layer 18 is disposed adjacent to one side of the reflective layer 15 away from the second substrate 14, and is disposed corresponding to the reflective layer 15. The light absorbing layer 18 may be, for example but not limited to, a black photoresist layer, which may form a black matrix (BM) layer.

As shown in FIG. 1, when the ambient light L2 is incident from the upper side of the light reflection area 142 of the second substrate 14, it will be reflected by the reflective layer 15 located below the light reflection area 142. In addition, when the ambient light L1 is incident from the upper side of the light transmission area 141 of the second substrate 14, it will first pass through the optical layer 16 and then be reflected by the electronic unit 13 (or the traces of the circuit layer 12) located below the light transmission area 141. The reflected light will produce color cast due to the electronic unit 13. In this case, the optical layer 16 can effectively reduce the intensity of the reflected ambient light L1 by scattering, polarizing and/or refracting the ambient light L1, thereby improving the granular color cast phenomenon of the mirror image.

FIGS. 2A to 2E are schematic sectional views of different aspects of the electronic device according to the first embodiment of this invention, wherein the optical layer 16 is, for example, a circular polarizer.

As shown in FIG. 2A, compared with the previous embodiment of FIG. 1, the optical layer of the electronic device 10a is a circular polarizer 16a. The circular polarizer 16a can eliminate at least a part of the ambient light L1 after polarization, which can effectively reduce the light intensity of the reflected ambient light L1, thereby improving the granular color cast phenomenon of the mirror image. In the present embodiment, the material of the circular polarizer 16a can be formed on the second substrate 14, the reflective layer 15 and the light absorbing layer 18 by using a coating process, and then can be patterned by laser etching, photolithography process, etc. to form the circular polarizer 16a. In this case, the thickness of the circular polarizer 16a is, for example but not limited to, between 1µm and 20µm, and the material of the circular polarizer 16a can be, for example, a stack of lyotropic liquid crystal, a mixed material of lyotropic liquid crystal and dichroic dye, which can, for example, form a phase retarder and a linear polarizer respectively.

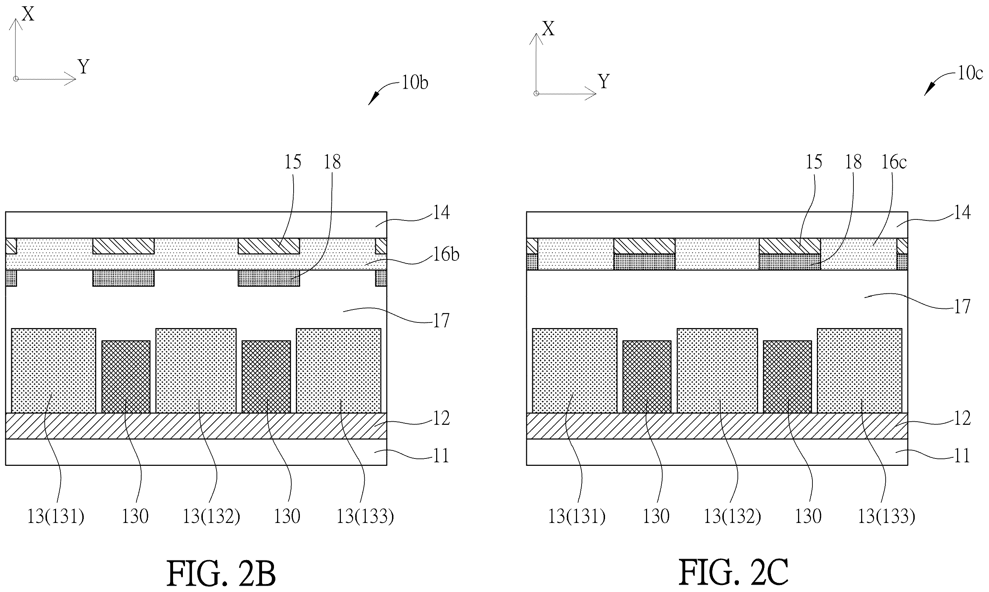

As shown in FIG. 2B, compared with the previous embodiment of FIG. 2A, in the electronic device 10b, the circular polarizer 16b is disposed below the second substrate 14 and the reflective layer 15, and the light absorbing layer 18 is disposed below the circular polarizer 16b. That is, the circular polarizer 16b is located between the reflective layer 15 and the light absorbing layer 18.

As shown in FIG. 2C, compared with the previous embodiment of FIG. 2A, in the electronic device 10c, the circular polarizer 16c is disposed below the second substrate 14, and is located between adjacent groups of the reflective layers 15 and the light absorbing layers 18, wherein each group includes one reflective layer 15 and one light absorbing layer 18. In one embodiment, the circular polarizer 16c does not extend to the position under the light absorbing layers 18. In another embodiment, the circular polarizer 16c extends to the position under a part of the light absorbing layers 18.

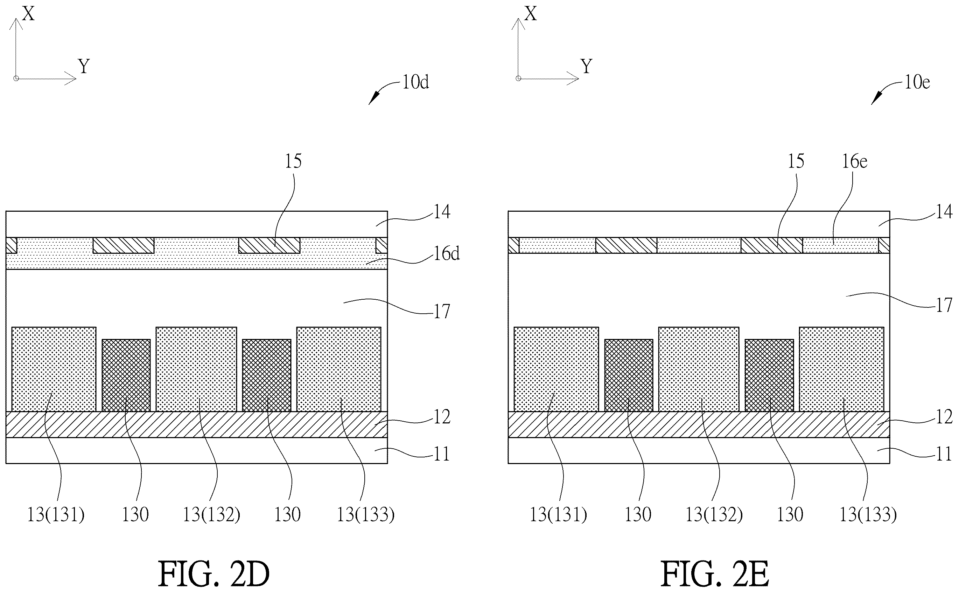

As shown in FIG. 2D, compared with the previous embodiment of FIG. 2A, the electronic device 10d is not configured with the light absorbing layers 18, and the circular polarizer 16d is disposed below the second substrate 14 and the reflective layer 15.

As shown in FIG. 2E, compared with the previous embodiment of FIG. 2C, the electronic device 10e is not configured with the light absorbing layers 18, and the circular polarizer 16e is disposed below the second substrate 14 and is located between the adjacent reflective layers 15. In one embodiment, the circular polarizer 16e does not extend to the position under the reflective layer 15. In another embodiment, the circular polarizer 16e extends to the position under a part of the reflective layer 15.

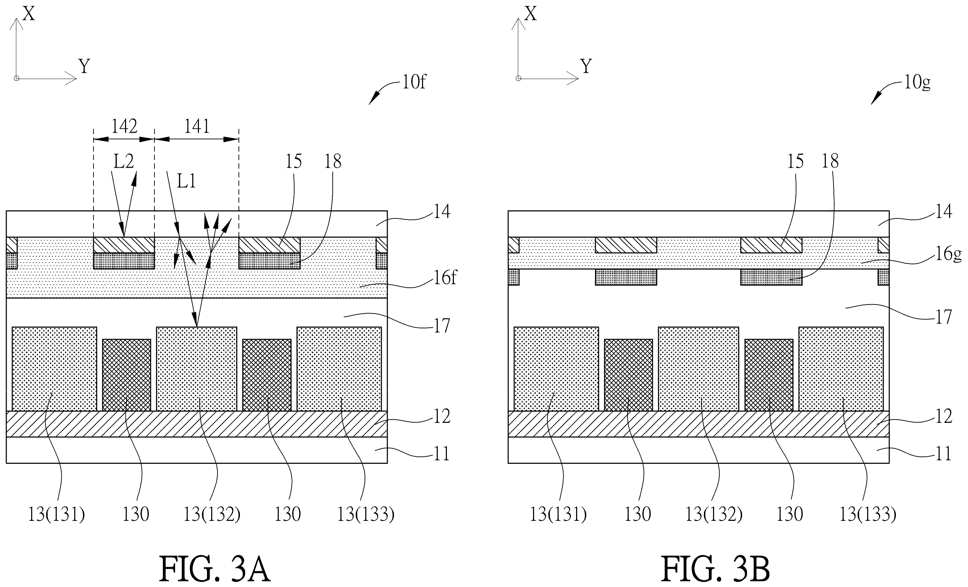

FIGS. 3A to 3D are schematic sectional views of different aspects of the electronic device according to the first embodiment of this invention, wherein the optical layer 16 is, for example, a scattering layer.

As shown in FIG. 3A, compared with the previous embodiment of FIG. 1, the optical layer of the electronic device 10f is a scattering layer 16f. The scattering layer 16f can scatter the ambient light L1, which can effectively reduce the light intensity of the reflected ambient light L1, thereby improving the granular color cast phenomenon of the mirror image. In the present embodiment, the material of the scattering layer 16f can be formed on the second substrate 14, the reflective layer 15 and the light absorbing layer 18 by using a coating process, and then can be patterned by laser etching, photolithography process, etc. to form the scattering layer 16f. In this case, the thickness of the scattering layer 16f is, for example but not limited to, between 1µm and 20µm, and the material of the scattering layer 16f can be, for example, a transparent scattering material, such as a mixed material of titanium dioxide (TiO₂) particles, air particles (bubbles) and polymer resin.

As shown in FIG. 3B, compared with the previous embodiment of FIG. 3A, in the electronic device 10g, the scattering layer 16g is disposed below the second substrate 14 and the reflective layer 15, and the light absorbing layer 18 is disposed below the scattering layer 16g. That is, the scattering layer 16g is located between the reflective layer 15 and the light absorbing layer 18.

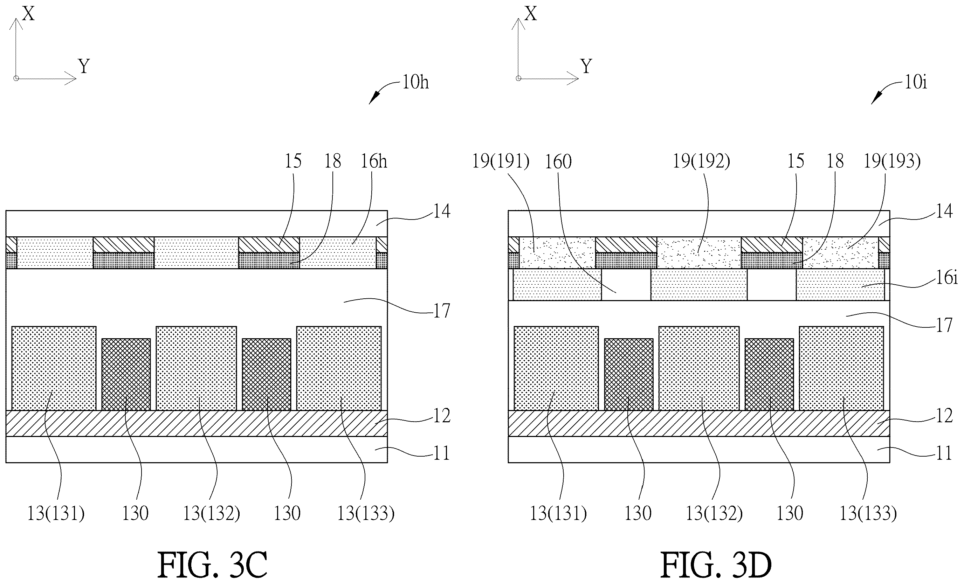

As shown in FIG. 3C, compared with the previous embodiment of FIG. 3A, in the electronic device 10h, the scattering layer 16h is disposed below the second substrate 14, and is located between adjacent groups of the reflective layers 15 and the light absorbing layers 18, wherein each group includes one reflective layer 15 and one light absorbing layer 18. In one embodiment, the scattering layer 16h does not extend to the position under the light absorbing layers 18. In another embodiment, the scattering layer 16h extends to the position under a part of the light absorbing layers 18.

As shown in FIG. 3D, compared with the previous embodiment of FIG. 3A, the electronic device 10i further includes a color filter layer 19, which is disposed between the scattering layer 16i (the optical layer) and the light transmission area 141 of the second substrate 14. In one pixel of the electronic device 10i, each color filter layer 19 includes, for example, three color filter elements 191, 192 and 193, which are respectively disposed above the light-emitting elements 131, 132 and 133. In this embodiment, the three color filter elements 191, 192 and 193 may be, for example, a red filter element, a green filter element, and a blue filter element, which correspond to a red micro LED, a green micro LED, and a blue micro LED, respectively. The above description is for an example and is not intended to limit the scope of the present invention.

In practice, as shown in FIG. 3D, the circuit layer 12, the unit definition layer 130, and the electronic unit 13 are formed on the first substrate 11. In addition, the reflective layer 15 and the light absorbing layer 18 are sequentially formed on the light reflection area 142 of the second substrate 14, and the color filter layer 19 (e.g. including three color filter elements 191, 192 and 193) is formed on the light transmission area 141 of the second substrate 14. Then, a bank layer 160 is formed on the light absorbing layer 18, and the bank layer 160 is patterned to form a plurality of accommodation spaces. Afterwards, the optical layer 16 is filled into the plurality of accommodation spaces of the bank layer 160. Finally, a sealant or an adhesive material layer is provided to bond the structure including the first substrate 11 to the structure including the second substrate 14 to form the electronic device 10i.

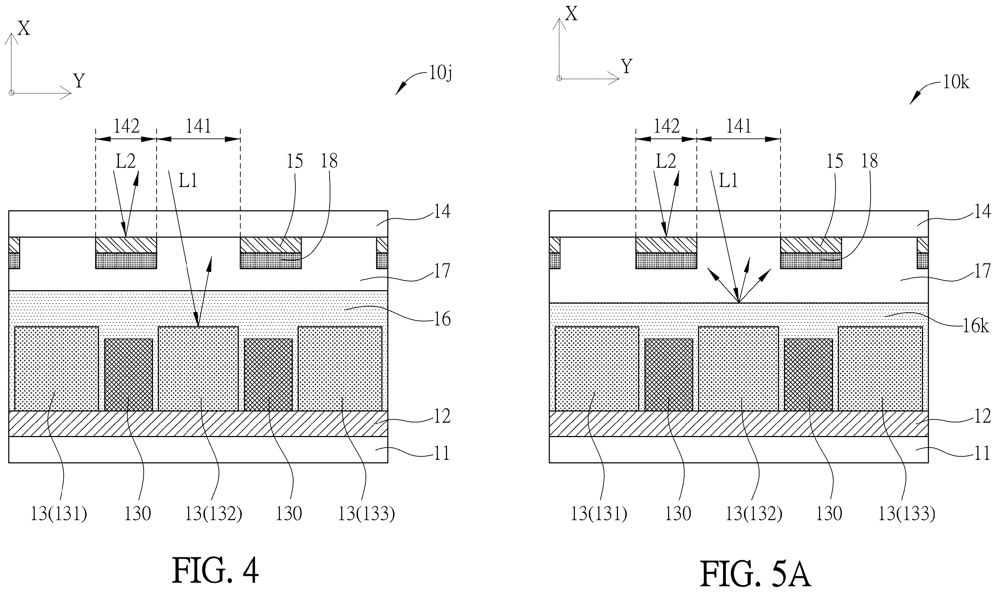

As shown in FIG. 4, compared with the previous embodiment of FIG. 1, the optical layer 16 of the electronic device 10j is disposed between the intermediate layer 17 and the electronic unit 13. When the ambient light L2 is incident from the upper side of the light reflection area 142 of the second substrate 14, it will be reflected by the reflective layer 15 located below the light reflection area 142. In addition, when the ambient light L1 is incident from the upper side of the light transmission area 141 of the second substrate 14, it will first pass through the intermediate layer 17 and the optical layer 16, and then be reflected by the electronic unit 13 (or the traces of the circuit layer 12) located below the light transmission area 141. The reflected light will produce color cast due to the electronic unit 13. In this case, the optical layer 16 can effectively reduce the intensity of the reflected ambient light L1 by scattering, polarizing and/or refracting the ambient light L1, thereby improving the granular color cast phenomenon of the mirror image.

FIGS. 5A to 5D are schematic sectional views of different aspects of the electronic device according to the second embodiment of this invention. In this embodiment, the optical layer 16 includes, for example, transparent organic material, and the refractive index of the optical layer 16 may be, for example, less than that of the intermediate layer 17. In addition, the optical layer 16 may include a plurality of air bubbles, so that the optical layer 16 can provide refraction and scattering on the ambient light, thereby effectively reducing the light intensity of the reflected ambient light.

As shown in FIG. 5A, compared with the previous embodiment of FIG. 4, the optical layer of the electronic device 10k is a low-refraction material layer 16k. In this embodiment, the refractive index of the low-refraction material layer 16k is relatively less than that of the intermediate layer 17. For example, the refractive index of the low-refraction material layer 16k can be between 1.0 and 1.5 (e.g. 1.3), and the refractive index of the intermediate layer 17 can be 1.5 or more. Accordingly, the low-refraction material layer 16k can provide a refraction effect on the ambient light, so that it can reduce the component of the light with color cast, which is reflected by the electronic unit 13 or the traces of the circuit layer 12, thereby reducing the light intensity of the reflected ambient light.

As mentioned above, the low-refraction material layer 16k may include, for example, a mixing material containing air particles (bubbles) and a polymer resin (transparent organic material), which may be patterned by using the photolithography process, and the thickness of the low-refraction material layer 16k may be, for example but not limited to, between 1 µm and 20 µm. In addition, the configuration of the low-refraction material layer 16k can increase the light outputting efficiency of the underlying electronic unit 13 by, for example, at least 10%.

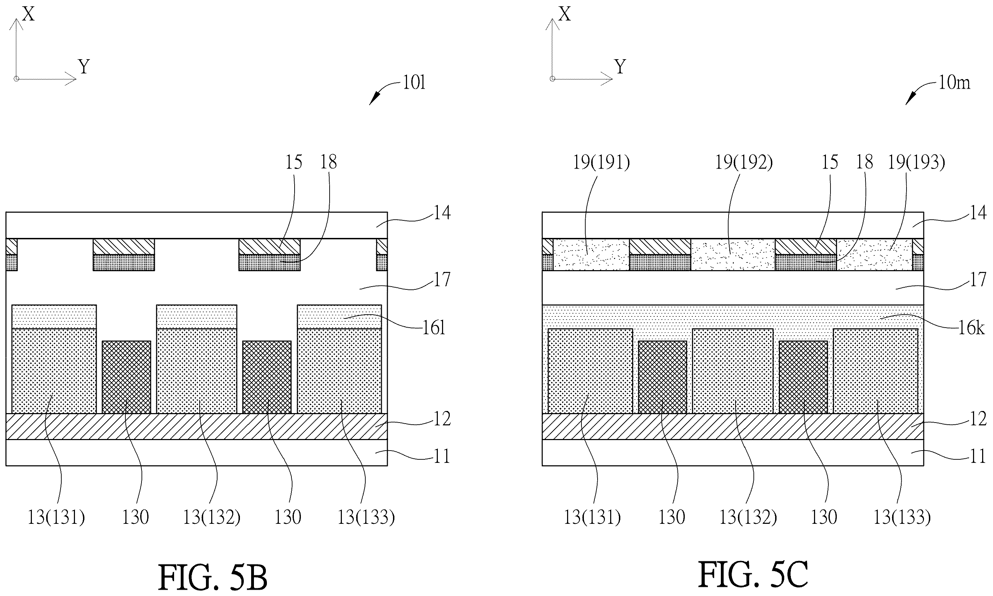

As shown in FIG. 5B, compared with the previous embodiment of FIG. 5A, in the electronic device 101, the low-refraction material layer 161 is disposed corresponding to the light transmission area 141, and located above the electronic unit 13. That is, the low-refraction material layer 161 is not arranged at the position below the light absorbing layer 18. In another embodiment, the low-refraction material layer 161 may extend to the position below a part of the light absorbing layer 18.

As shown in FIG. 5C, compared with the previous embodiment of FIG. 5A, the electronic device 10m further includes a color filter layer 19, which is disposed between the intermediate layer 17 and the light transmission area 141 of the second substrate 14.

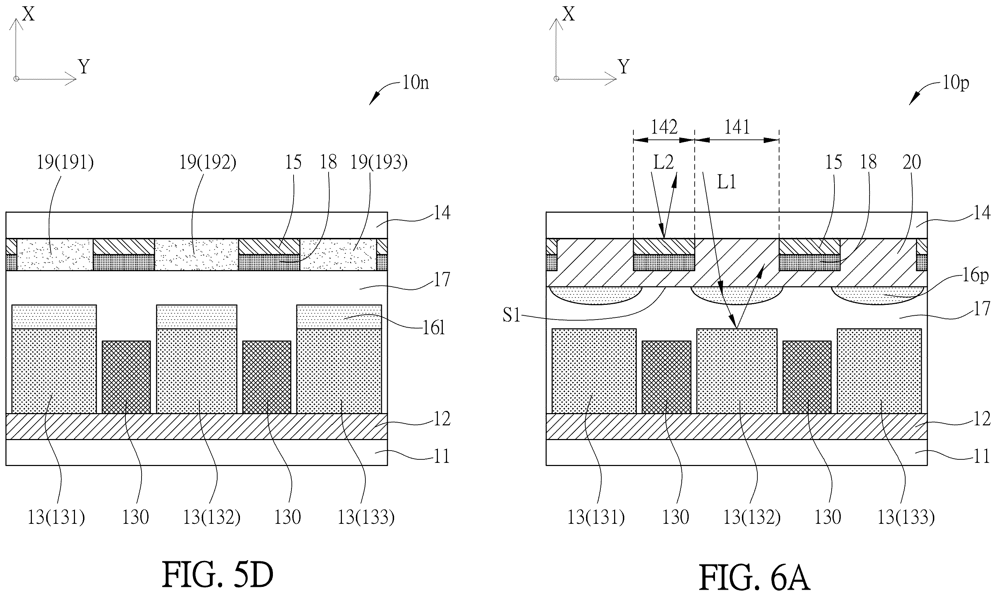

As shown in FIG. 5D, compared with the previous embodiment of FIG. 5B, the electronic device 10n further includes a color filter layer 19, which may include three color filter elements 191, 192 and 193, disposed between the intermediate layer 17 and the light transmission area 141 of the second substrate 14.

FIGS. 6A to 6D are schematic sectional views of different aspects of the electronic device according to a third embodiment of this invention.

As shown in FIG. 6A, compared with the previous embodiment of FIG. 1, the optical layer of the electronic device 10p includes at least one micro lens structure 16p. In addition, the electronic device 10p further includes a planarization layer 20 disposed between the micro lens structure 16p and the second substrate 14, and the planarization layer 20 covers the reflective layer 15 and the light absorbing layer 18. In one pixel of the electronic device 10p, the electronic device 10p includes, for example, three micro lens structures 16p, which are respectively arranged below the light transmission area 141 and above the light-emitting elements 131, 132 and 133. One side of the planarization layer 20 away from the second substrate 14 can be, for example, a planarized surface S1, and the micro lens structures 16p are disposed on the planarized surface S1. Since the micro lens structures 16p can provide refraction or total reflection to the ambient light L1, the ambient light L1 can be, for example, refracted or totally reflected to a position not observed by the user or absorbed by the light absorbing layer 18. Therefore, this configuration can effectively reduce the light intensity of the reflected ambient light L1 and thereby improve the granular color cast phenomenon of the mirror image.

In this embodiment, the refractive index of the micro lens structures 16p can be designed to be greater than the refractive indexes of the intermediate layer 17 and the planarization layer 20, so as to achieve the aforementioned refraction or total reflection effect. In addition, on the projection plane perpendicular to the first direction X, the projections of the micro lens structures 16p may, for example, at least completely cover the projections of the light-emitting elements 131, 132 and 133, respectively. That is, the length of the projection of each micro lens structure 16p can be greater than or equal to the length of the projection of the corresponding light-emitting element 131, 132 or 133, and the width of the projection of each micro lens structure 16p can be greater than or equal to the width of the projection of the corresponding light-emitting element 131, 132 or 133. In addition, the length or width of the projection of each micro lens structure 16p may be, for example, smaller than the pitch of the light-emitting elements 131, 132 and 133 in the length direction or the width direction, so that any adjacent two micro lens structures 16p do not overlap with one another. In this embodiment, the thickness of the micro lens structure 16p can be, for example, less than or equal to the distance between each light-emitting element 131, 132 or 133 and the planarization layer 20. That is, the thickness of the micro lens structure 16p can be, for example, less than or equal to the thickness of the intermediate layer 17. In this embodiment, the thickness of the micro lens structure 16p can be, for example, between 1 µm and 30 µm. It should be noted that the above description is for an example and is not intended to limit the scope of the present invention.

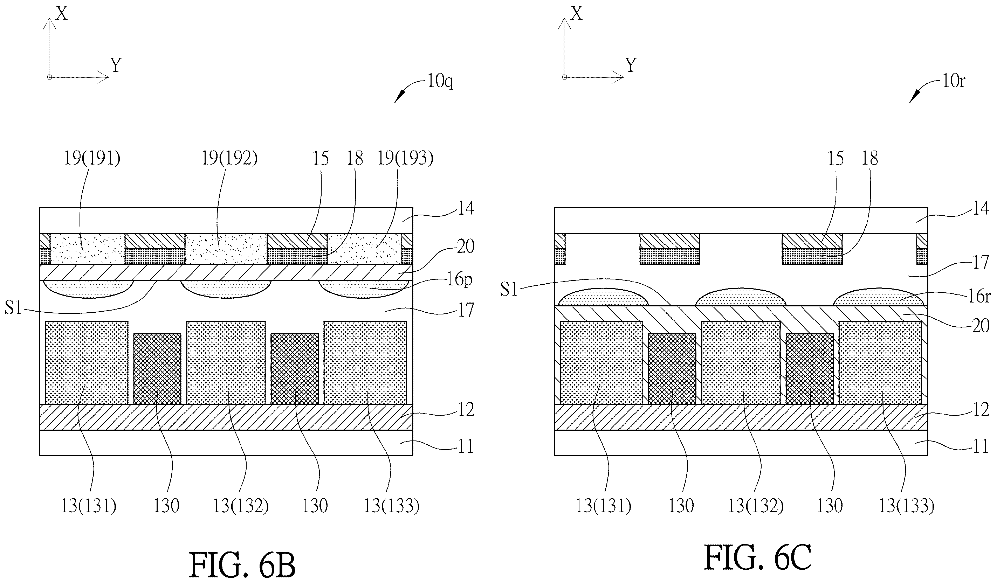

As shown in FIG. 6B, compared with the previous embodiment of FIG. 6A, the electronic device 10q further includes a color filter layer 19, which may include three color filter elements 191, 192 and 193, disposed between the planarization layer 20 and the light transmission area 141 of the second substrate 14.

As shown in FIG. 6C, compared with the previous embodiment of FIG. 4, the optical layer of the electronic device 10r includes at least one micro lens structure 16r. In addition, the electronic device 10r further includes a planarization layer 20 disposed between the micro lens structure 16r and the first substrate 11, and the planarization layer 20 covers the light-emitting elements 131, 132 and 133. In one pixel of the electronic device 10r, the electronic device 10r includes, for example, three micro lens structures 16r, which are respectively arranged below the light transmission area 141 and above the light-emitting elements 131, 132 and 133. One side of the planarization layer 20 away from the first substrate 11 can be, for example, a planarized surface S1, and the micro lens structures 16r are disposed on the planarized surface S1. In this embodiment, the thickness of the micro lens structure 16r can be, for example, less than or equal to the distance between the light absorbing layer 18 and the planarization layer 20. That is, the thickness of the micro lens structure 16r can be, for example, less than or equal to the thickness of the intermediate layer 17. In this embodiment, the thickness of the micro lens structure 16p can be, for example, between 1 µm and 30 µm. It should be noted that the above description is for an example and is not intended to limit the scope of the present invention. Since the micro lens structures 16r can provide refraction or total reflection to the ambient light L1, the ambient light L1 can be, for example, refracted or totally reflected to a position not observed by the user or absorbed by the light absorbing layer 18. Therefore, this configuration can effectively reduce the light intensity of the reflected ambient light L1 and thereby improve the granular color cast phenomenon of the mirror image.

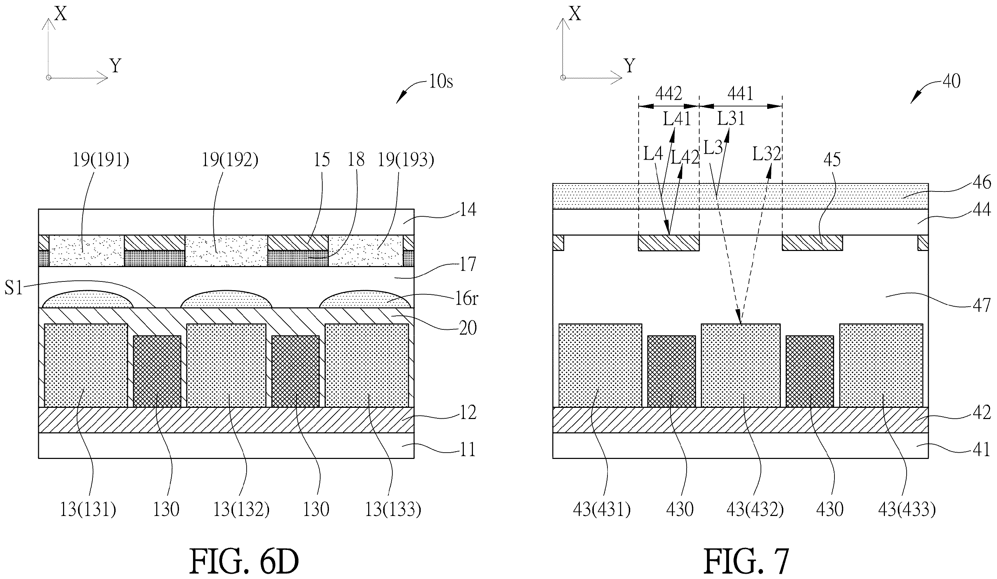

As shown in FIG. 6D, compared with the previous embodiment of FIG. 6C, the electronic device 10s further includes a color filter layer 19, which may include three color filter elements 191, 192 and 193, disposed between the intermediate layer 17 and the light transmission area 141 of the second substrate 14. In this embodiment, the thickness of the micro lens structure 16r can be, for example, less than or equal to the distance between the planarization layer 20 and the color filter layer 19 (or the light absorbing layer 18). That is, the thickness of the micro lens structure 16r can be, for example, less than or equal to the thickness of the intermediate layer 17.

In other embodiments, each micro lens structure 16r may be directly disposed on the upper surface of the corresponding light-emitting element 131, 132 or 133, and this invention is not limited thereto. In this case, the planarized surface S1 of the planarization layer 20 may be coplanar with the upper surface of the light-emitting elements 131, 132 and 133, or the planarization layer 20 may be omitted. It should be noted that the above description is for an example and is not intended to limit the scope of the present invention.

As mentioned above, the optical layer can effectively reduce the intensity of the reflected ambient light by scattering, polarizing and/or refracting the ambient light, thereby improving the granular color cast phenomenon of the mirror image.

As shown in FIG. 7, the electronic device 40 of this embodiment can be, for example, a mirror display device, especially a micro LED mirror display device. For example, FIG. 7 shows a sectional view of a pixel region of the electronic device 40, which is defined in a plane formed by a first direction X and a second direction Y.

In this embodiment of FIG. 7, the electronic device 40 includes a first substrate 41, a circuit layer 42, at least one electronic unit 43, a second substrate 44, a reflective layer 45, a reflection enhancement layer 46, and an intermediate layer 47.

The first substrate 41 may include, for example but not limited to, transparent or non-transparent organic and/or inorganic materials, and the material thereof may include rigid material or flexible soft material. The organic material may include, for example but not limited to, polyimide (PI), polycarbonate (PC), polyethylene terephthalate (PET), or any of other known suitable materials, or a combination thereof. The inorganic material may include, for example but not limited to, glass, quartz, sapphire, or ceramic. In this embodiment, the material of the substrate 41 is glass as an example, so that the first substrate 41 is a glass substrate.

The circuit layer 42 is disposed on the first substrate 41 in the first direction X. The circuit layer 42 may include, for example, different passive components and/or active components, such as resistors, capacitors, inductors, diodes, MOSFETs, CMOS transistors, BJTs, LDMOS transistors, PMOS transistors, TFTs, or other types of transistors. In addition, the first substrate 41 and the circuit layer 42 can together constitute a driving substrate for driving the electronic unit 43, which can be, for example but not limited to, a CMOS substrate, a LCOS substrate, a TFT substrate, or other circuit substrates with operating circuits. In this embodiment, the first substrate 41 and the circuit layer 42 can together constitute, for example, a TFT substrate.

The electronic unit 43 is disposed over the first substrate 41 and electrically connected to the circuit layer 42. In this embodiment, the electronic unit 43 may be, for example, directly disposed on the circuit layer 42 and electrically connected to the circuit layer 42. In one embodiment, the electronic unit 43 may be, for example but not limited to, a light-emitting unit. In this case, a unit definition layer 430 (or pixel definition layer) may be formed on the circuit layer 42, and it may be made of, for example, a negative photoresist and have a plurality of accommodating spaces arranged along the second direction Y. Each electronic unit 43 (light-emitting unit) may, for example, include three light-emitting elements 431, 432 and 433, which are respectively arranged in the accommodating spaces of the unit definition layer 430. In other embodiments, each electronic unit 43 may include any suitable active or passive components. For example, each light-emitting element 431, 432 or 433 may include an organic LED (OLED), an inorganic LED (e.g. mini LED or micro LED), or a quantum-dot LED (QLED), but the present invention is not limited thereto. In this embodiment, the three light-emitting elements 431, 432 and 433 may be, for example, a red micro LED, a green micro LED, and a blue micro LED, respectively.

The second substrate 44 is disposed opposite to the first substrate 41 and includes at least one light transmission area 441 and at least one light reflection area 442. The light transmission area 441 is disposed next to the light reflection area 442. In this embodiment, the second substrate 44 includes a plurality of light transmission areas 441 and a plurality of light reflection areas 442, which are disposed adjacent to each other and are alternately arranged. The plurality of light transmission areas 441 are arranged corresponding to the plurality of light-emitting elements 431, 432 and 433 of the electronic unit 43, respectively. The second substrate 44 may be, for example but not limited to, a transparent substrate, such as a glass substrate. In addition, the width of the light transmission area 441 may be equal to, slightly larger than, or slightly smaller than the width of the corresponding electronic unit 43.

The reflective layer 45 is disposed at one side of the second substrate 44 close to the first substrate 41 and corresponding to the light reflection area 442. In this embodiment, a reflective material layer may be formed on one side of the second substrate 44, and then the portions of the reflective material layer corresponding to the plurality of light transmission areas 441 are removed. Accordingly, the residual portions of the reflective material layer corresponding to the plurality of light reflection areas 442 can form the reflective layer 45. The material of the reflective layer 45 can be, for example, a single metal layer, a composite metal layer, a multilayer film material, or a layer of any of other suitable materials. The single metal layer may include, for example, silver, aluminum, or the likes. The composite metal layer may include, for example, a composite structure of metals and metal oxides, such as, for example but not limited to, ITO/Ag/ITO, Ag/ITO, Al/Ag/Al, Ag/Al, or the likes. The multilayer film material may include, for example, a multilayer film with at least three layers of different refractive indices, wherein the high refractive layers and the low refractive layers are interposed with each other. The low refractive material can be, for example but not limited to, SiOx, and the high refractive material can be, for example but not limited to, SiNx, niobium oxide (Nb₂O₅), or the likes.

The reflection enhancement layer 46 is disposed at one side of the second substrate 44 away from the first substrate 41, and is configured to reflect at least part of the ambient light. For example, the reflection enhancement layer 46 may be a multilayer film formed by interlacing at least two materials, which have different refractive indices, so that the multilayer film formed by the interlaced materials has a high-low interlaced refractive index configuration. This configuration can effectively reflect the first polarized light portion of the incident ambient light and allowing the second polarized light portion of the incident ambient light to pass through. In this case, the two materials included in the reflection enhancement layer 46 may, for example, include polyethylene naphthalate (PEN) and PEN copolymer (coPEN), the first polarized light portion may, for example, be S-polarized light), and the second polarized light portion may, for example, be P-polarized light.

The intermediate layer 47 is disposed between the first substrate 41 and the second substrate 44. In this embodiment, as shown in FIG. 7, the reflective layer 45 is disposed on the lower surface of the second substrate 44 in the first direction X. Therefore, a part of the intermediate layer 47 corresponding to the light reflection area 442 is located between the reflective layer 45 and the first substrate 41, and a part of the intermediate layer 47 corresponding to the light transmission area 441 is located between the first substrate 41 and the second substrate 44. The intermediate layer 47 can be, for example but not limited to, an air medium, an optical clear adhesive (OCA), or an optical clear resin (OCR), which is not limited in the present invention. In one embodiment, when manufacturing the electronic device 40, the circuit layer 42 and the electronic unit 43 can be disposed on the first substrate 41, and the reflective layer 45 can be disposed on the second substrate 44. Then, a sealant can be provided to bond the structures on the first substrate 41 and the structures on the second substrate 44. In this case, the intermediate layer 47 can be, for example, an air medium, and the reflective layer 45 is located between the first substrate 41 and the second substrate 44. Finally, the reflection enhancement layer 46 is disposed on one side of the second substrate 44 away from the first substrate 41. In another embodiment, an adhesive material layer can be used to bond the structures on the first substrate 41 and the structures on the second substrate 44. The adhesive material layer can be, for example, an optical clear adhesive or an optical clear resin, and the adhesive material layer can be solidified to form the intermediate layer 47. In this case, the intermediate layer 47 can be, for example, a layer including the optical clear adhesive or the optical clear resin.

As shown in FIG. 7, one side of the reflection enhancement layer 46 is in direct contact with the second substrate 44, while the other side of the reflection enhancement layer 46 is in contact with the ambient medium. Therefore, when the ambient light L3 and L4 travel in the ambient medium and are incident toward the electronic device 40, they will first be incident on the reflection enhancement layer 46. The reflection enhancement layer 46 can reflect part of the ambient lights L3 and L4. For example, the reflection enhancement layer 46 can reflect the first polarized light portion L31 of the ambient light L3 and the first polarized light portion L41 of the ambient light L4, while the second polarized light portion L32 of the ambient light L3 and the second polarized light portion L42 of the ambient light L4 can penetrate the reflection enhancement layer 46. Then, the second polarized light portion L42 incident on the light reflection area 442 of the second substrate 44 will be reflected by the reflective layer 45 located below the light reflection area 442. In this case, the reflected first polarized light portion L41 and the reflected second polarized light portion L42 have no color cast. In addition, the second polarized light portion L32 incident on the light transmission area 441 of the second substrate 44 will first pass through the intermediate layer 47 and then be reflected by the electronic unit 43 (or the traces of the circuit layer 42) located below the light transmission area 441, and this reflected light will produce color cast due to the electronic unit 43 (or the traces of the circuit layer 42). In this case, since part of the ambient light L3 (e.g. the first polarized light portion L31) is directly reflected by the reflection enhancement layer 46, the reflected first polarized light portion L31 has no color cast, and the electronic unit 43 (or the traces of the circuit layer 42) reflects part of the ambient light L3 (e.g. the second polarized light portion L32). Therefore, this configuration can effectively reduce the intensity of the reflected light with color cast (e.g. the second polarized light portion L32), thereby improving the granular color cast phenomenon of the mirror image. In addition, the total reflectivity of the ambient light L4 at the light reflection area 442 in the case configured with the reflection enhancement layer 46 will be greater than the total reflectivity of the ambient light here in the case without the reflection enhancement layer 46, and the total reflectivity of the ambient light L3 at the light transmission area 441 in the case configured with the reflection enhancement layer 46 will be greater than the total reflectivity of the ambient light here in the case without the reflection enhancement layer 46.

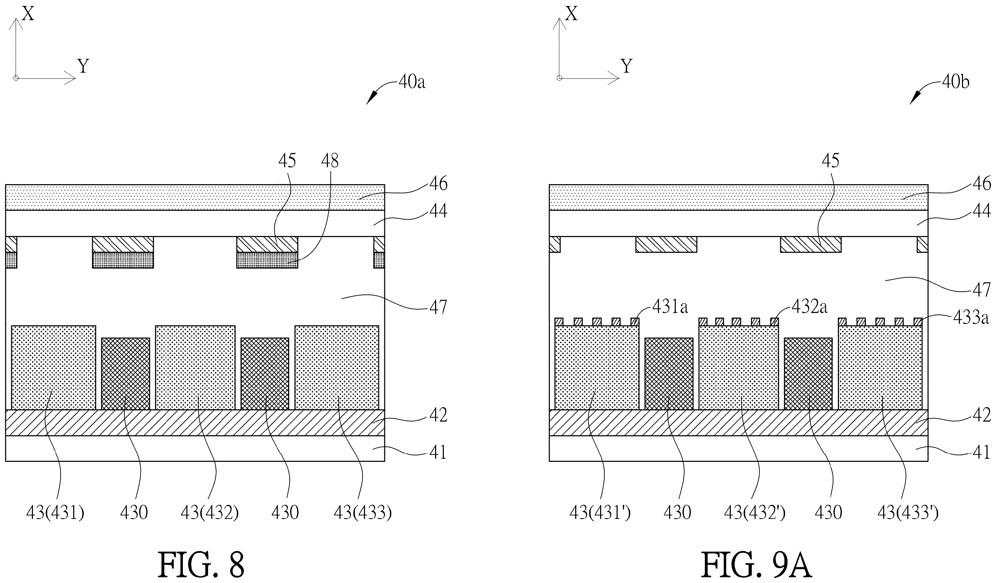

As shown in FIG. 8, compared with the previous embodiment of FIG. 7, the electronic device 40a further includes a light absorbing layer 48 disposed at one side of the reflective layer 45 away from the second substrate 44. The light absorbing layer 48 is disposed adjacent to one side of the reflective layer 45 away from the second substrate 44, and is disposed corresponding to the reflective layer 45. The light absorbing layer 48 may be, for example but not limited to, a black photoresist layer, which may form a black matrix (BM) layer. The width of the light absorbing layer 48 in the second direction Y may be, for example, slightly greater than, slightly less than, or equal to the width of the corresponding reflective layer 45 in the second direction Y.

As shown in FIG. 9A, compared with the previous embodiment of FIG. 7, in the electronic device 40b, the electronic unit 43 includes a polarized electronic unit. The polarized electronic unit has a microstructure, and the microstructure is disposed at a side of the polarized electronic unit close to the second substrate 44. In this embodiment, each electronic unit 43 may be, for example, a polarized light-emitting unit, which includes, for example, three polarized light-emitting elements 431', 432' and 433' respectively arranged in the accommodating spaces of the unit definition layer 430. In this case, the polarized light-emitting element 431' includes a microstructure 431a, the polarized light-emitting element 432' includes a microstructure 432a, and the polarized light-emitting element 433' includes a microstructure 433a. The microstructures 431a, 432a and 433a are respectively wire grid structures. The wire grid structure is, for example, a grating structure composed of a plurality of parallel metal wires, wherein the spacing between two adjacent metal wires in the second direction Y is, for example, between 30 nm and 300 nm, and the height of each metal wire in the first direction X is, for example, between 20 nm and 200 nm. The material of the metal wires includes, for example but not limited to, silver or aluminum, and the wire grid structure may be formed by patterning a metal material layer by using laser ablation, photolithography, etc.

In this embodiment, the electronic device 40b is configured with the microstructures 431a, 432a and 433a that contain wire grid structures, so that the electronic unit 43 can, for example, include polarized light-emitting elements 431', 432' and 433'. The polarization direction of the polarized light-emitting elements 431', 432' and 433' can be the same as the polarization direction (e.g. P-polarized light) allowed to penetrate the reflection enhancement layer 46, so that the lights emitted by the polarized light-emitting elements 431', 432' and 433' can penetrate the reflection enhancement layer 46. Therefore, the intensities of the lights emitted by the polarized light-emitting elements 431', 432' and 433' do not decrease after passing through the reflection enhancement layer 46.

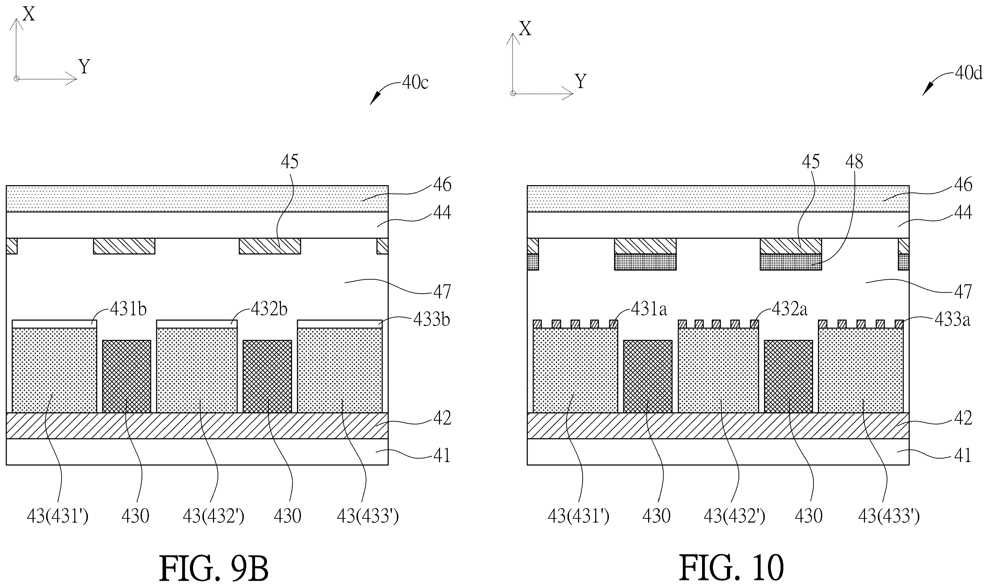

As shown in FIG. 9B, compared with the previous embodiment of FIG. 9A, in the electronic device 40c, the polarized light-emitting element 431' includes a microstructure 431b, the polarized light-emitting element 432' includes a microstructure 432b, and the polarized light-emitting element 433' includes a microstructure 433b. The microstructures 431b, 432b and 433b are respectively meta lens structures. The meta lens structure is, for example, formed by periodically arranging nanometer-sized columnar elements, which can polarize the light passing therethrough. The meta lens structure can be formed, for example, by deep ultraviolet lithography, nanoimprinting, or any of other suitable processes.

As shown in FIG. 10, compared with the previous embodiment of FIG. 9A, the electronic device 40d further includes a light absorbing layer 48 disposed at one side of the reflective layer 45 away from the second substrate 44. The light absorbing layer 48 is disposed adjacent to one side of the reflective layer 45 away from the second substrate 44, and is disposed corresponding to the reflective layer 45. The light absorbing layer 48 may be, for example but not limited to, a black photoresist layer, which may form a black matrix (BM) layer. The width of the light absorbing layer 48 in the second direction Y may be, for example, slightly greater than, slightly less than, or equal to the width of the corresponding reflective layer 45 in the second direction Y, which is not limited in the present invention. In addition, the electronic device 40d of this embodiment is configured with the microstructures 431a, 432a and 433a as shown in FIG. 9A (i.e., wire grid structures). In other embodiments, the electronic device 40d of this embodiment may be configured with the microstructures 431b, 432b and 433b as shown in FIG. 9B (i.e., meta lens structures).

To be noted, without departing from the spirit of the present invention, the features in several different embodiments may be replaced, reorganized, or mixed to complete other embodiments. For example, the optical layers (including the circular polarizer, scattering layer, low-refraction material layer, micro lens structure, etc.) of the first, second and third embodiments may be applied to any of the fourth to seventh embodiments. Similarly, the reflection enhancement layer 46 and/or the microstructures 431a, 432a and 433a or 431b, 432b and 433b of the fourth to seventh embodiments may be applied to any of the first, second and third embodiments. This invention is not limited.

As mentioned above, since the reflection enhancement layer can reflect a part of the ambient light (e.g. the first polarized light portion), and the remaining part of the ambient light (e.g. the second polarized light portion) is incident on the electronic unit (or the trace of the circuit layer), the intensity of the reflected light with color cast can be effectively reduced, thereby improving the granular color cast phenomenon of the mirror image.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. An electronic device, comprising:
a first substrate;
a circuit layer disposed on the first substrate;
at least one electronic unit disposed above the first substrate and electrically connected to the circuit layer;
a second substrate disposed opposite to the first substrate and comprising at least one light transmission area and at least one light reflection area, wherein the light transmission area is located next to the light reflection area, and the light transmission area is arranged corresponding to the electronic unit;
a reflective layer disposed at one side of the second substrate close to the first substrate, and located corresponding to the light reflection area; and
an optical layer disposed between the second substrate and the electronic unit, and located at least corresponding to the light transmission area.

2. The electronic device of claim 1, further comprising:
an intermediate layer disposed between the first substrate and the second substrate.

3. The electronic device of claim 2, wherein the optical layer is disposed between the intermediate layer and the second substrate.

4. The electronic device of claim 3, wherein the optical layer comprises a plurality of scattering particles or a circular polarizer.

5. The electronic device of claim 3, wherein the reflective layer is disposed between the optical layer and the second substrate.

6. The electronic device of claim 2, further comprising:
a color filter layer disposed between the optical layer and the light transmission area of the second substrate.

7. The electronic device of claim 2, further comprising:
a light absorbing layer disposed between the reflective layer and the intermediate layer.

8. The electronic device of claim 2, wherein the optical layer is disposed between the intermediate layer and the electronic unit.

9. The electronic device of claim 8, wherein the optical layer comprises a transparent organic material, and a refractive index of the optical layer is less than a refractive index of the intermediate layer.

10. The electronic device of claim 1, wherein the optical layer comprises at least one micro lens structure.

11. The electronic device of claim 10, further comprising:
a planarization layer disposed between the micro lens structure and the second substrate, wherein the planarization layer covers the reflective layer, and a thickness of the micro lens structure is less than or equal to a distance between the electronic unit and the planarization layer.

12. The electronic device of claim 10, further comprising:
a planarization layer disposed between the micro lens structure and the first substrate, wherein the planarization layer covers the electronic unit.

13. An electronic device, comprising:
a first substrate;
a circuit layer disposed on the first substrate;
at least one electronic unit disposed above the first substrate and electrically connected to the circuit layer;
a second substrate disposed opposite to the first substrate and comprising at least one light transmission area and at least one light reflection area, wherein the light transmission area is located next to the light reflection area, and the light transmission area is arranged corresponding to the electronic unit;
a reflective layer disposed at one side of the second substrate close to the first substrate, and located corresponding to the light reflection area; and
a reflection enhancement layer disposed at one side of the second substrate away from the first substrate to reflect at least part of an ambient light.

14. The electronic device of claim 13, wherein the ambient light comprises a first polarized light portion and a second polarized light portion, the reflection enhancement layer reflects the first polarized light portion and allows the second polarized light portion to pass through.

15. The electronic device of claim 13, wherein the electronic unit comprises a polarized electronic unit having a microstructure, the microstructure is arranged at one side of the polarized electronic unit close to the second substrate, and a light emitted from the polarized electronic unit penetrates the reflection enhancement layer.
